# EUROPEAN PATENT SPECIFICATION

(11) **EP 1 576 662 B1**
(45) Date of publication and mention of the grant of the patent: **26.10.2011**
(21) Application number: 03772538.9
(22) Date of filing: 20.11.2003
(51) Int. Cl.: H01L 21/762, H01L 21/20

(54) **STRESS-FREE COMPOSITE SUBSTRATE AND METHOD OF MANUFACTURING SUCH A COMPOSITE SUBSTRATE**
BELASTUNGSFREIES ZUSAMMENGESETZTES SUBSTRAT UND VERFAHREN ZUR HERSTELLUNG EINES SOLCHEN ZUSAMMENGESETZTEN SUBSTRATS
SUBSTRAT COMPOSITE SANS CONTRAINTE ET SON PROCEDE DE FABRICATION

(30) Priority: 19.12.2002 EP 02080620
(43) Date of publication of application: 21.09.2005
(73) Proprietor: NXP B.V., 5656 AG Eindhoven (NL)
(72) Inventor: HAISMA, Jan, NL-5656 AA Eindhoven (NL)
(74) Representative: Schouten, Marcus Maria
(86) International application number: PCT/IB2003/005409
(87) International publication number: WO 2004/057663

(56) References cited:
- EP-A- 0 809 288
- EP-A- 1 213 748
- SPIERING V L ET AL: "SACRIFICIAL WAFER BONDING FOR PLANARIZATION AFTER VERY DEEP ETCHING" JOURNAL OF MICROELECTROMECHANICAL SYSTEMS, IEEE INC. NEW YORK, US, vol. 4, no. 3, 1 September 1995 (1995-09-01), pages 151-157, XP000531458 ISSN: 1057-7157

## Description

The invention relates to a composite substrate comprising a carrier composed of a carrier material, a first layer composed of a first material, and an intermediate layer composed of a second material being located between the carrier and the first layer.

The invention further relates to a method of manufacturing such a composite substrate.

Silicon-on-insulator (SOI) comprises a silicon wafer with a thin insulating layer, generally an oxide layer such as silicon dioxide, buried in it. Devices or integrated circuits are built into a thin layer of silicon on top of the buried insulating layer, the silicon layer also being called a device layer.

SOI substrates provide superior isolation between adjacent devices in an integrated circuit as compared to devices built into bulk silicon wafers. This is due to elimination of latch-up in CMOS devices, a condition in which significant current flows between NMOS and PMOS structures. SOI devices also have e.g. an improved performance due to reduced parasitic capacitances.

Nowadays, some restrictions limit a main stream applicability of SOI wafers.

First, the thermal expansion of silicon (26x10⁻⁷/°C) and of thermal silicon dioxide (5x10⁻⁷/°C) are so different from each other, that an SOI wafer shows a significant amount of compressive stress in the silicon dioxide layer, and tensile stress in the thin silicon device layer. The larger the SOI wafer, the more severe this problem is. For 300 mm diameter SOI wafers, this is a serious problem. Experiments have shown that integrated circuits on SOI can suffer substantially from severe stress corrosion due to this tension/stress profile. The problem of stress due to bonding in SOI wafers is described a.o. in W. P. Maszara et al., "Role of surface morphology in wafer bonding", J. Appl. Phys. 69(1), p.257-p.260, 1 January 1991. In this document, local stresses due to the bonding process are estimated to be about 1x10⁸ dynes/cm². This stress is reduced about 100 times for thin (0.5 µm) SOI films.

Secondly, the properties of SOI do not yet surpass bulk-silicon properties sufficiently in such a way that the extra costs for manufacturing of SOI justify its application on a large scale. Therefore, SOI is, so far, not yet cost-competitive with bulk silicon.

It is known from US-5281834 to bond a non-silicon substrate to a silicon substrate with a stress-relief layer between both substrates, which stress-relief layer reduces the stress between both substrates. The stress is created by the difference in thermal expansion coefficients between both substrates. The stress-relief layer is a low melting-point metal, a semiconductor layer having its thermal expansion coefficient close to (preferably within approximately 25%-35% of) the thermal expansion coefficient of the non-silicon substrate. Such a stress-relief layer is what is called a compliant layer, see Haisma et al., Materials Science & Engineering Reports R37 (2002) 1-60, specifically p. 47 and 51-52 and the literature cited therein, where misfit-transforming bonding is described. In such cases dilatation-misfit is not eliminated, merely somewhat diminished by stress transfer from an active semiconductive layer to a passive intermediate layer. Such an intermediate layer is a stress-buffering layer, whereby, within certain limits, occurrence of dislocations in the active material is prevented.

US-5102821 describes a method of forming an SOI wafer from two individual wafers by bonding whereby the integral wafer bonding process is said to be less sensitive to particulates (to prevent voids), surface flatness and polishing circumstances. The method comprises forming a layer of metal on a carrier, forming an insulator on a second wafer, forming a bonding layer over the insulator, anisotropically etching the bonding layer, forming chambers in the bonding layer, stacking the first and second wafers with the metal against the second wafer's bonding layer, forming a chemical bond between the metal layer and the bonding layer in a vacuum chamber, thereby creating micro-vacuum chambers between the wafers, and selectively etching the second wafer to form a thin semiconductor layer. It is a process, comprising a grid with distributed vacuum holes. The grid itself is dilatation mismatch sensitive because the linear dimensions remain intact and therefore it manifests itself not as a compressive-stress-free nor as a tensile-stress-free layer. So, the structure suffers from stress and strain in the different layers. This cumbersome bonding process is not high-end silicon-technology compatible due to the intermediate metallic layer, even if it has been sandwiched between diffusion-resistive layers.

European patent application, publication number EP-A-1,213 748 A2, discloses a method of bonding a semiconductor wafer to a patterned carrier wafer.

It is an object of the invention of the type mentioned in the opening paragraph to obtain a composite substrate that is substantially stress free.

The object according to the invention is achieved in that the first material has a dilatation behavior being substantially the same as that of the carrier material, and having a dilatation mismatch with the second material, the intermediate layer having structures of second material for absorbing stress originating from the dilatation mismatch.

In case the second material of the intermediate layer has a dilatation that is different from the carrier material and the first material, there is a dilatation mismatch. The dilatation mismatch results in stress. This stress is usually strongest close to the transition between the materials having a dilatation mismatch. The stress is relieved in the structures being present in the intermediate layer. The structures can elastically deform and can therefore absorb the stress. The first layer has no or very few defects and devices manufactured in it have improved electrical characteristics.

Preferably the structures extend through the thickness of the intermediate layer in order to improve the absorption of stress originating from the dilatation mismatch between the carrier material and the second material of the intermediate layer. The structures have a free surface, which can elastically deform. Stress and strain can easily be relieved at the free surface. Dislocations move to the surface and disappear from the structures. The result is a stress free first layer.

The extension of the structures in the carrier improves the stress and strain relaxation. Especially at corners the stress is usually high. By burying the corners in the carrier material, the enhanced stress in the corners is no longer located near the interface between the carrier and the intermediate layer. Moreover the increased free surface of the structures improves the stress relieve.

A stress free composite substrate can be obtained when the carrier material is the same as the first material. The composite substrate no longer suffers from warp.

The carrier and first materials may be semiconductors, such as for example, but not limited thereto, silicon.

The second material of the intermediate layer may be an amorphous material. The second material may comprise an oxidized semiconductor material, such as silicon dioxide. The second material may comprise thermally oxidized semiconductor material, such as thermally grown silicon dioxide. By doing this, a stress-free first layer on top of stress-free structures is obtained. On insulating material, the stress in the first layer is usually tensile stress, because the dilatation of the insulating material is usually much less than the dilatation of semiconductor material.

The structures of the composite substrate may be generated by patterning the intermediate layer by applying millimeter, micrometer or nanometer structural texturing, or by applying imprint lithography. The structures may be obtained by reactive ion-etching.

The intermediate layer and the carrier lay in a plane. The dimensions of the structures in the plane of the intermediate layer may be of millimeter, micrometer or nanometer order of magnitude. The structures may have a line-symmetric shape in a cross-section perpendicular to the plane of the carrier. The structures may have a symmetrical shape in a cross-section parallel to the plane of the carrier, for example a circular, square, rectangular or rhombic shape.

The second solid-state wafer may be contact bonded, direct bonded and annealed, or covalently bonded to the structures of the intermediate layer.

It is advantageous for stress relieve when the dimension of the structures are between 10 µm and 10 nm, preferably between 100 nm and 25 nm. These structures can easily elastically deform.

According to an embodiment of the present invention, a composite substrate according to the present invention may be a silicon-on-insulator (SOI) substrate, comprising as a carrier a silicon substrate, as an intermediate layer an insulation layer provided with structures, and as a first layer a silicon wafer secured, for example by bonding, to the structures of the insulation layer. The silicon wafer may be thinned to a required thickness for a SOI device layer.

It is a further object of the invention to obtain a method for producing a stress-free composite substrate, which method is compatible with semiconductor processing.

The object according to the invention is achieved in that the method to relieve stress in a composite substrate, comprises the steps of:
providing a carrier, composed of a carrier material, with on top thereof an intermediate layer of a second material,
forming in the intermediate layer structures which extend through the intermediate layer,
bonding on the intermediate layer a first substrate of a first material having a dilatation behavior being substantially the same as that of the carrier material.

The structures can be free-standing before the first wafer is bonded. After bonding a stress-free first wafer on top of the structures is obtained. Stress originating from the dilatation mismatch between the first layer and the second layer is absorbed in the structures of the intermediate layer. The first substrate may form a device wafer, possibly to be thinned, of a first material. Therefore, the first layer has no or very few defects and improved electrical characteristics.

Preferably the structures are formed into the carrier. The extension of the structures into the carrier increases the free surfaces area of the structures, which facilitates the stress relieve. Preferably the corners in the carrier are gradual to reduce stress.

The carrier material and the first material may be the same material in order to prevent warp. The carrier material and the first material may be monocrystalline, for example isotropic monocrystalline material. If they are monocrystalline, the carrier material and the first material have a crystallographic orientation, wherein the crystallographic orientation of the carrier material and the first material may be the same. The carrier material and the first material may be semiconductor materials, such as for example, but not limited to, silicon.

The second material may be an amorphous material. The second material may comprise an oxidized semiconductor material, such as silicon dioxide for example. The second material may comprise thermally oxidized semiconductor material, such as thermally grown silicon dioxide.

The structures of the composite substrate may be generated by patterning the intermediate layer by applying millimeter, micrometer or nanometer structural texturing, by applying imprint lithography or by self-assembled structuring techniques. The structures may be obtained by reactive ion-etching.

According to an embodiment of the present invention, the forming of the structures may be executed by integrally patterning the structures over the intermediate layer, i.e. by patterning the structures all over the intermediate layer.

According to another embodiment of the present invention, the forming of the structures may be executed by distributedly or locally patterning the structures in clusters over the intermediate layer, i.e. by patterning the structures only on those locations of the intermediate layer where they are necessary, or at locations where stress is likely to occur.

The patterning may comprise applying millimeter, micrometer or nanometer structural texturing, preferably structural texturing of the intermediate layer well into the carrier material. This means that the structures are free-standing pillars or similar geometries of the second material on top of the carrier of carrier material.

Alternatively, the patterning may comprise applying imprint lithography. The structures may be obtained by reactive ion-etching of the intermediate layer.

The intermediate layer and the carrier lay in a plane. According to the present invention, the forming of the structures may be such that the dimensions of the structures in the plane of the intermediate layer are very small, e.g. of millimeter, but preferably of micrometer or nanometer order of magnitude. The forming of the structures may be such that the structures have a line-symmetric shape in a cross-section perpendicular to the plane of the carrier. The forming of the structures may be such that the structures have a symmetrical shape in a cross-section parallel to the plane of the carrier, e.g. a circular, square, rectangular or rhombic shape.

The dimension of the structures may be between 10 µm and 10 nm, preferably between 100 nm and 25 nm.

The bonding of the first wafer on the intermediate layer may for example be executed by contact bonding, e.g. by direct bonding and annealing, by ultra-high vacuum bonding or by covalent bonding. Before the bonding process takes place, native oxide on the first wafer is removed, e.g. with ozone in a vacuum chamber.

A method according to the present invention may furthermore comprise thinning the first wafer to an adequate device-layer thickness, e.g. to a required thickness for an SOI device layer. The thinning may be executed by electrochemical means, by means of grinding and defect-free polishing, or by means of adequate ion-implantation and low-temperature annealing.

According to an embodiment of the present invention, a composite substrate according to the present invention may be a silicon-on-insulator (SOI) substrate, comprising as a carrier a silicon substrate wafer, as an intermediate layer an insulation layer provided with structures, and as a first layer a silicon device wafer which is bonded to the structures of the insulation layer and subsequently thinned to a required thickness to be used as a SOI device layer.

The present invention also provides the use of a method according to the present invention for making a composite substrate e.g. a solid-state material-on-insulator substrate, more specifically a semiconductor-on-insulator substrate and still more specifically a silicon-on-insulator substrate.

These and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.
Fig. 1 is a schematic vertical cross-section of a silicon wafer.
Fig. 2 is a schematic vertical cross-section of a thermally oxidized silicon wafer.
Fig. 3 is a schematic vertical cross-section of a thermally oxidized silicon wafer provided with structures according to an embodiment of the present invention.
Fig. 4 is a schematic vertical cross-section of the device of Fig. 3, onto which a further silicon layer is bonded.
Fig. 5 shows the structure of Fig. 4 after thinning of the device wafer.

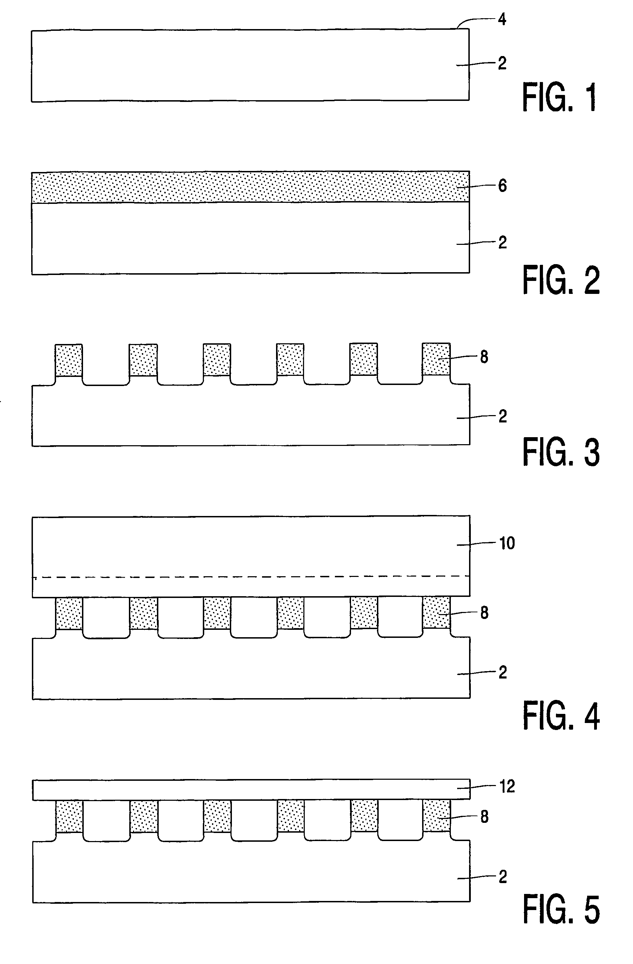

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. For example, the size of the structures in Figs. 3 to 5 is exaggerated.

Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

Nano-imprint-lithography, also known as mold-assisted nanolithography, basically concerns the manufacture of a 'compact disc' in its finest information bearing details, and then imprinted into silicon. It has been described in Jan Haisma et al., "Mold-assisted nano-lithography: a process for reliable pattern replication", J. Vacuum Science & Techn., B14 (1996), 4124-4128.

Nano-imprint-lithography is a process for producing devices with dimensions of structures having dimensions below 100 nm. It is a two-step process: first, an imprinting step is carried out, after which pattern transfer is realized through e.g. wet or dry etching into the substrate material. During the imprinting step, a mould with nanostructures on its surface is used to deform a thin resist film or an active material deposited on a substrate. The resist can be a thermal plastic, a UV-curable or thermal curable polymer, or some other suitable deformable material. The image transfer system consists of only a heating source or a UV light source, which is very simple and cheap compared with the sources (light or particles) and lenses of other processes to make small structures, such as for example extreme-UV lithography, ion-beam projection lithography, x-ray lithography or electron-beam lithography. In the pattern-transfer step, an anisotropic etching process such as reactive ion-etching (RIE) is used to transfer the microstructure pattern into the substrate-material and to remove the residual resist in the compressed area, transferring the thickness variety pattern created by the imprint into the entire resist, i.e. for the lowest parts entirely into the substrate-wafer material.

For nano-imprint-lithography, first a mould is made e.g. with an Electron Beam Pattern Generator (EBPG). The EBPG draws patterns on the mould material using electron beam technologies, by switching the electron beam on and off in a vacuum, and by moving the stage on which the drawing object (the mask) is set.

As represented in Fig. 2 of J. Haisma et al, "Mold-assisted nanolithography: A process for reliable pattern replication", J. Vac. Sci. Technol. B 14 (1996), p. 4124-4128, the surfaces of the mould and the substrate are cleaned and are provided with a release layer, for example Montacell C from Seppic, Paris, France, which can be applied by means of immersion, and a primer, respectively. Then copies are made from this mould. A thin layer of a UV-curable material, e.g. 1,6-hexanediol-diacrylate (HDDA), including dimethoxy-phenylacetophenone (DMPA) as a photoinitiator, is applied to the substrate by means of spin coating. The mould and the substrate are aligned and are pressed together. The HDDA is solidified through UV exposure. The mould is removed from the substrate. An etch back of the HDDA, e.g. in an O₂/He plasma, is realized to open the recessed structures completely. The HDDA layer is then used as a mask for processing the substrate further. The obtained pattern is then imprinted into Si or SiO₂. Thereafter, the remaining HDDA can be stripped, e.g. via dry (oxygen) plasma etching or wet chemistry.

The resolution of nano-imprint-lithography is determined by the mechanical strength of the mould and polymer. As described in "Nanoimplint Lithography and Lithographically Induced Self-Assembly", Stephen Y. Chou, MRS Bulletin, July 2001, when using a silicon dioxide mould and polymethyl methacrylate (PMMA) resists, holes 6 nm in diameter and 60 nm deep in PMMA and PMMA pillars 30 nm in diameter and 35 nm tall have been achieved using nano-imprint-lithography. Furthermore, it is mentioned in this document that, with a suitable resist and mould, the resolution of nano-imprint-lithography can be below 5 nm.

Nano-imprint-lithography has the characteristics that it is small, it is economical and it is compatible with semiconductor technology.

Different kinds of nano-imprint-lithography imprinting machines are described in the article from MRS Bulletin, July 2001, by Chou: a single-imprint machine which imprints a single wafer at one time, a step-and-repeat machine which imprints a small area (called a die) of a wafer at a time and then moves to a new area of the wafer, and a roller machine, either using a cylindrical mould or using a smooth roller over a flat mould.

According to an embodiment of the present invention, a combination of nano-imprint-lithography and direct bonding provides a reasonably cheap method of making tensile stress-free SOI.

An embodiment of the method of the present invention is as follows, as represented in Fig. 1 to Fig. 5.

In a first step, a carrier 2, such as a substrate or silicon wafer, is present, as shown in Fig. 1. In embodiments of the present invention, the term "substrate" may include any underlying material or materials that may be used, or upon which an insulating layer may be formed. In other alternative embodiments, this "substrate" may include a semiconductor substrate such as e.g. a doped silicon, a gallium arsenide (GaAs), a gallium arsenide phosphide (GaAsP), a germanium (Ge), or a silicon germanium (SiGe) substrate. The term "substrate" is used to define generally the elements for layers that underlie an insulating layer of interest. Also, the "substrate" may be any other base on which a layer is formed, for example a glass or metal layer. In the following, processing will mainly be described with reference to silicon processing but the skilled person will appreciate that the present invention may be implemented based on other semiconductor material systems and that the skilled person can select suitable materials as equivalents of the dielectric, semiconductive and conductive materials described below.

The silicon wafer is thermally oxidized, as shown in Fig. 2. Therefore, on a free surface 4 of the silicon wafer 2, a silicon dioxide layer 6 is formed.

In a second step, as represented in Fig. 3, the oxidized surface 6 is patterned thereby forming structures 8 by nano-imprint-lithography as explained herein above. The structures may have any suitable shape, such as e.g. a pillar shape or a truncated pyramid shape. The structures 8 preferably have a diameter in the order of between 10 µm and 10 nm, more preferred between 100 nm and 25 nm.

This nano-imprint pattern is imprinted, for example by reactive ion-etching, firstly into the SiO₂ layer 6, and next through the SiO₂ layer 6 into the silicon of the substrate wafer 2. This means that the structures 8 are free-standing SiO₂ pillars on top of substrate silicon 2.

This patterned wafer is bonded by direct bonding, or by covalent bonding, to a device wafer 10, as shown in Fig. 4. Before bonding, the surface of the device wafer is cleaned. Native oxide is removed by ozone in a vacuum chamber.

The bonded device wafer 10 is thereafter thinned to a required SOI thickness (see the dashed line in Fig. 4) so as to form a device layer 12 of the SOI, as shown in Fig. 5. This thinning may be done e.g. by a smart cut, or in any suitable way known to a person skilled in the art to obtain a thin device layer 12.

The result is a tensile stress-free thin silicon layer 12 on top of a stress-free insulated microstructure 8, the latter incorporated into substrate silicon 2. With tensile stress-free SOI is meant: insulated silicon with much better electrical characteristics than SOI known from the prior art. Stress-free SOI does not suffer from stress corrosion. Stress-free SOI gives the active elements in the upper silicon layer 12 a chance of upgrading, for example linearising, of the characteristics. The influence of hydrostatic and localized-pressure on electrical properties of several semiconductor (Si, Ge) junctions like: p-n, p-i-n and p-s-n (s indicating "slightly doped"), transistors and diodes, has been studied experimentally and theoretically in great detail in the past. Reference can be made to the extensive investigations of K. Bulthuis, published in Philips Res. Reports 20 (1965) 415-431; J. Appl. Phys. 37 (1966) 2066-2068; Philips Res. Reports 21 (1966) 85-103 and Philips Res. Reports 23 (1968) 25-47. Large changes in the semiconductor characteristics as a function of pressure have been calculated, measured and explained.

There are no or very few defects in the resulting thin silicon device layer 12. Thermal silicon dioxide 6 keeps a crystal structure over two to three atomic layers on the grown silicon side, after which the oxide is an amorphous substance. Such a thin substance is both very elastic and relatively plastic under local pressure. The profile of the structures 8 will adapt themselves under stress and strain.

As soon as bonding has been carried out, the SOI wafer can be annealed so that all defects of the reactive ion-etching disappear. This is, however, not necessary, as the pillars 8 themselves and the open space around the pillars add to the electrical insulation. The substrate 2 is only a carrier that does not need to be monocrystalline silicon.

Whatever may be the temperature budget of the processing later on, significant tensile stress will not occur in the SOI composition according to the present invention. In such a set-up, if bulk silicon reaches its ultimate limits, SOI on top of structures will surpass bulk silicon properties in advanced dedicated integrated circuitry.

## Claims

1. A composite substrate comprising a carrier composed of a carrier material, a first layer composed of a first material, and an intermediate layer composed of a second material being located between the carrier and the first layer, wherein the first material has a dilatation behavior being the same as that of the carrier material, and having a dilatation mismatch with the second material **characterised in that** the intermediate layer has structures of second material with dimensions, in the plane of the intermediate layer, between 10µm and 10nm.

2. A composite substrate according to claim 1, wherein the intermediate layer has a thickness, and the structures extend through the thickness of the intermediate layer.

3. A composite substrate according to claim 1, wherein the structures further extend into the carrier.

4. A composite substrate according to claim 1, wherein the carrier material is the same as the first material.

5. A composite substrate according to any of the previous claims, wherein the carrier material and the first material are semiconductors.

6. A composite substrate according to any of the previous claims, wherein the second material is an electrically insulating material.

7. A composite substrate according to any of the previous claims, wherein the carrier lies in a plane and wherein the structures have a line-symmetric shape in a cross-section perpendicular to the plane of the carrier.

8. A composite substrate according to any of the previous claims, wherein the carrier lies in a plane and wherein the structures have a circular, square, rectangular or rhombic shape in a cross-section parallel to the plane of the carrier.

9. A composite substrate according to any of the previous claims, wherein the composite substrate is a silicon-on-insulator wafer.

10. A composite substrate according to any of the previous claims, wherein the dimensions of the structures are between 100nm and 25nm.

11. A method to relieve stress in a composite substrate, comprising:
providing a carrier, composed of a carrier material, with on top thereof an intermediate layer of a second material,
forming in the intermediate layer structures which extend through the intermediate layer,
bonding on the intermediate layer a first substrate of a first material having a dilatation behavior being substantially the same as that of the carrier material,
wherein the forming of the structures is executed by patterning the structures in the intermediate layer, and
wherein the patterning comprises applying imprint lithography.

12. A method according to claim 11, in which the structures are formed into the carrier.

13. A method according to claim 11 or 12, wherein the forming of the structures is executed by locally patterning the structures in clusters over the intermediate layer.

14. A method according to any of claims 11 to 13, wherein the patterning comprises applying structural texturing, wherein the dimensions in the plane of the intermediate layer of the second material are between 10µm and 10nm.

15. A method according to any of claims 11-13, wherein the patterning comprises applying structural texturing, wherein the dimensions in the plane of the intermediate layer of the second material are between 100nm and 25nm.

16. A method according to any of claims 11 to 15, wherein the carrier lies in a plane, and wherein the forming of the structures is such that the structures have a line-symmetric shape in a cross-section perpendicular to the plane of the carrier.

17. A method according to any of claims 11 to 16, wherein the carrier lies in a plane, and wherein the forming of the structures is such that the structures have a circular, square, rectangular or rhombic shape in a cross-section parallel to the plane of the carrier.

18. Use of the method of any of claims 11 to 17 for making a silicon-on-insulator substrate.

## Patentansprüche

1. Verbundsubstrat enthaltend einen Träger, der aus einem Trägermaterial aufgebaut ist, eine erste Schicht, die aus einem ersten Material aufgebaut ist, und eine Zwischenschicht, die aufgebaut ist aus einem zweiten Material, welches zwischen dem Träger und der ersten Schicht angeordnet ist, wobei das erste Material ein Ausdehnungsverhalten aufweist, welches dasselbe ist wie das des Trägermaterials, und eine Ausdehnungsdiskrepanz mit dem zweiten Material aufweist, **dadurch gekennzeichnet, dass** die Zwischenschicht Strukturen des zweiten Materials mit Abmessungen, in der Ebene der Zwischenschicht, zwischen 10 µm und 10 nm aufweist.

2. Verbundsubstrat gemäß Anspruch 1, wobei die Zwischenschicht eine Dicke aufweist und die Strukturen sich durch die Dicke der Zwischenschicht erstrecken.

3. Verbundsubstrat gemäß Anspruch 1, wobei die Strukturen sich ferner in den Träger erstrecken.

4. Verbundsubstrat gemäß Anspruch 1, wobei das Trägermaterial dasselbe ist wie das erste Material.

5. Verbundsubstrat gemäß irgendeinem der vorhergehenden Ansprüche, wobei das Trägermaterial und das erste Material Halbleiter sind.

6. Verbundsubstrat gemäß irgendeinem der vorhergehenden Ansprüche, wobei das zweite Material ein elektrisch isolierendes Material ist.

7. Verbundsubstrat gemäß irgendeinem der vorhergehenden Ansprüche, wobei der Träger in einer Ebene liegt und wobei die Strukturen eine achsensymmetrische Form in einem Querschnitt senkrecht zu der Ebene des Trägers aufweisen.

8. Verbundsubstrat gemäß irgendeinem der vorhergehenden Ansprüche, wobei der Träger in einer Ebene liegt und wobei die Strukturen eine kreisförmige, quadratische, rechteckige oder rhombische Form in einem Querschnitt parallel zu der Ebene des Trägers aufweisen.

9. Verbundsubstrat gemäß irgendeinem der vorhergehenden Ansprüche, wobei das Verbundsubstrat ein Silizium-auf-Isolator-Wafer ist.

10. Verbundsubstrat nach irgendeinem der vorhergehenden Ansprüche, wobei die Abmessungen der Strukturen zwischen 100 nm und 25 nm liegen.

11. Verfahren zum Abbauen von Spannungen in einem Verbundsubstrat, enthaltend:
Bereitstellen eines Trägers, der aus einem Trägermaterial aufgebaut ist, mit einer Zwischenschicht aus einem zweiten Material darauf,
Bilden, in der Zwischenschicht, von Strukturen, welche sich durch die Zwischenschicht erstrecken,
Bonden, auf die Zwischenschicht, ein erstes Substrat aus einem ersten Material, welches ein Ausdehnungsverhalten aufweist, das im Wesentlichen dasselbe ist wie das des Trägermaterials,
wobei das Bilden der Strukturen durchgeführt wird durch Strukturieren der Strukturen in der Zwischenschicht, und
wobei das Strukturieren ein Anwenden einer Prägelithographie aufweist.

12. Verfahren gemäß Anspruch 11, in welchem die Strukturen in den Träger geformt werden.

13. Verfahren gemäß Anspruch 11 oder 12, wobei das Bilden der Strukturen durchgeführt wird durch lokales Strukturieren der Strukturen in Clustern über die Zwischenschicht.

14. Verfahren gemäß irgendeinem der Ansprüche 11 bis 13, wobei das Strukturieren ein Anwenden einer Gefügetexturierung aufweist, wobei die Abmessungen in der Ebene der Zwischenschicht aus dem zweiten Material zwischen 10 µm und 10 nm liegen.

15. Verfahren gemäß irgendeinem der Ansprüche 11 bis 13, wobei das Strukturieren ein Anwenden einer Gefügetexturierung aufweist, wobei die Abmessungen in der Ebene der Zwischenschicht aus dem zweiten Material zwischen 100 nm und 25 nm liegen.

16. Verfahren gemäß irgendeinem der Ansprüche 11 bis 15, wobei der Träger in einer Ebene liegt und wobei das Bilden der Strukturen so ist, dass die Strukturen eine Achsensymmetrieform in einem Querschnitt senkrecht zu der Ebene des Trägers aufweisen.

17. Verfahren gemäß irgendeinem der Ansprüche 11 bis 16, wobei der Träger in einer Ebene liegt und wobei das Bilden der Strukturen so ist, dass die Strukturen eine kreisförmige, quadratische, rechteckige oder rhombische Form in einem Querschnitt parallel zu der Ebene des Trägers aufweisen.

18. Verwendung des Verfahrens nach irgendeinem der Ansprüche 11 bis 17 zum Herstellen eines Silizium-auf-Isolator-Substrats.

## Revendications

1. Substrat composite comprenant un support composé d'un matériau de support, une première couche composée d'un premier matériau, et une couche intermédiaire composée d'un deuxième matériau située entre le support et la première couche, dans lequel le premier matériau a un comportement en matière de dilatation qui est le même que celui du matériau de support, ainsi qu'une disparité de dilatation par rapport au deuxième matériau, **caractérisé en ce que** la couche intermédiaire comprend des structures du deuxième matériau ayant des dimensions, dans le plan de la couche intermédiaire, comprises entre 10 µm et 10 nm.

2. Substrat composite selon la revendication 1, dans lequel la couche intermédiaire a une épaisseur, et les structures s'étendent à travers l'épaisseur de la couche intermédiaire.

3. Substrat composite selon la revendication 1, dans lequel les structures s'étendent en outre dans le support.

4. Substrat composite selon la revendication 1, dans lequel le matériau de support est le même que le premier matériau.

5. Substrat composite selon l'une quelconque des revendications précédentes, dans lequel le matériau de support et le premier matériau sont semi-conducteurs.

6. Substrat composite selon l'une quelconque des revendications précédentes, dans lequel le deuxième matériau est un matériau électriquement isolant.

7. Substrat composite selon l'une quelconque des revendications précédentes, dans lequel le support est situé dans un plan et dans lequel les structures ont une forme en ligne symétrique selon une coupe transversale perpendiculaire au plan du support.

8. Substrat composite selon l'une quelconque des revendications précédentes, dans lequel le support est situé dans un plan et dans lequel les structures ont une forme circulaire, carrée, rectangulaire ou rhombique selon une coupe transversale parallèle au plan du support.

9. Substrat composite selon l'une quelconque des revendications précédentes, le substrat composite étant une tranche de silicium sur isolant.

10. Substrat composite selon l'une quelconque des revendications précédentes, dans lequel les dimensions des structures sont comprises entre 100 nm et 25 nm.

11. Procédé pour alléger les contraintes dans un substrat composite, consistant à :
prévoir un support, composé d'un matériau de support, comprenant à sa partie supérieure une couche intermédiaire en un deuxième matériau,
former dans la couche intermédiaire des structures qui s'étendent à travers la couche intermédiaire,
fixer sur la couche intermédiaire un premier substrat en un premier matériau ayant un comportement en matière de dilatation qui est essentiellement le même que celui du matériau de support,
dans lequel la formation des structures est exécutée en configurant les structures dans la couche intermédiaire, et
dans lequel la configuration comprend l'application d'une lithographie par impression.

12. Procédé selon la revendication 11, dans lequel les structures sont formées dans le support.

13. Procédé selon la revendication 11 ou 12, dans lequel la formation des structures est exécutée en configurant localement les structures en groupes au-dessus de la couche intermédiaire.

14. Procédé selon l'une quelconque des revendications 11 à 13, dans lequel la configuration comprend l'application d'une définition de texture structurelle, dans lequel les dimensions dans le plan de la couche intermédiaire du deuxième matériau sont comprises entre 10 µm et 10 nm.

15. Procédé selon l'une quelconque des revendications 11 à 13, dans lequel la configuration comprend l'application d'une définition de texture structurelle, dans lequel les dimensions dans le plan de la couche intermédiaire du deuxième matériau sont comprises entre 100 nm et 25 nm.

16. Procédé selon l'une quelconque des revendications 11 à 15, dans lequel le support est situé dans un plan, et dans lequel la formation des structures est telle que les structures ont une forme en ligne symétrique selon une coupe transversale perpendiculaire au plan du support.

17. Procédé selon l'une quelconque des revendications 11 à 16, dans lequel le support est situé dans un plan, et dans lequel la formation des structures est telle que les structures ont une forme circulaire, carrée, rectangulaire ou rhombique selon une coupe transversale parallèle au plan du support.

18. Utilisation du procédé selon l'une quelconque des revendications 11 à 17 pour la fabrication d'un substrat en silicium sur isolant.
